Europäisches Patentamt

European Patent Office

Office européen des brevets

(11) Publication number: **0 279 638**
**A2**

# (12) EUROPEAN PATENT APPLICATION

(21) Application number: **88301294.0**

(22) Date of filing: **17.02.88**

(51) Int. Cl.⁴: **H 01 L 29/78**
**H 01 L 29/60**

(30) Priority: **18.02.87 US 15833**

(43) Date of publication of application:
**24.08.88 Bulletin 88/34**

(84) Designated Contracting States: **DE FR GB**

(71) Applicant: **XEROX CORPORATION**
**Xerox Square - 020**
**Rochester New York 14644 (US)**

(72) Inventor: **Thompson, Malcolm James**
**755 Stone Lane**
**Palo Alto California 94303 (US)**

(74) Representative: **Frain, Timothy John et al**
**Rank Xerox Limited Patent Department 364 Euston Road**
**London NW1 3BL (GB)**

(54) **Multi-gate thin film transistor.**

㊗ A thin film transistor (34) in which there is independent injection control of both electrons and holes into the charge transport layer (44). Control is achieved by a gate electrode (38 and 40) facing each of the electron and hole injecting electrodes (52 and 54). The injecting electrodes are contiguous with the charge transport layer and are laterally spaced from one another across a channel region (60) of the charge transport layer so that the respective charge carriers travel in opposite directions through the charge transport layer.hannel region.

FIG. 2

**Description**

MULTI-GATE THIN FILM TRANSISTOR

This invention relates to a thin film transistor device in which there is independent injection control of both electrons and holes into the charge transport layer so as to optimize the transistor performance and to obtain higher current output.

In our European patent application EP-A-0 156 528 (our reference D/84001), there is disclosed a device whose unique aspect is the orientation of the controlling gate electrode relative to the injecting electrode, collecting electrode and channel region. As configured, the gate is not used to change the conductivity of the channel region but to control the injection of charge carriers from the facing injecting electrode into the charge carrier transport layer sandwiched therebetween. Once charge carriers have been injected into the transport layer they come under the influence of the field created by the potential on the collecting electrode and they drift across the channel region of the transport layer, in a space charge limited manner. The resistance of the channel region is essentially unaffected by the changes in the gate voltage.

As in the device of EP-A-0 156 528, the advantages of the thin film transistor device of the present invention derive from the unique flexibility and simplicity of processing steps available to the fabrication of amorphous semiconductor devices and upon the somewhat unique transport properties of high band gap materials, such as amorphous silicon. These materials can be deposited uniformly, at relatively low temperatures (on the order of less than 350°C), over large area non-crystalline substrates, such as glass and ceramics, a large-area array of transistor structures, readily can be made. Two additional characteristics enable operation of the unique devices described herein. These are their high resistivity, causing them to behave similar to a dielectric material, and their ability to allow charge carriers to drift therethrough and to cause current flow once charge carriers are injected therein. Amorphous silicon germanium and amorphous silicon nitride are two other materials which may also be selected as the transport layer.

Although the device of EP-A-0 156 528 is capable of switching high voltages, on the order of 500 to 600 volts, the current output is relatively low, on the order of $10^{-7}$ amps.

According to the present invention a thin film transistor comprises a charge transport layer, an electron injecting electrode and a hole injecting electrode each contiguous therewith and laterally spaced from one another by a channel region of the transport layer. Injection controlling gate electrodes are associated with each of the charge injecting electrodes and positioned in facing relationship therewith. Each gate electrode is spaced from the transport layer by a gate dielectric layer so that each is spaced from its charge injecting electrode by the transport layer and the gate dielectric. The gate electrodes are also laterally spaced from one another by approximately the same distance as the lateral spacing between the charge injecting electrodes, so that they do not to overlie a major portion of the channel region.

The present invention enhances the device of the copending application by controlling the injection of oppositely charged carriers from the injection contacts into the charge transport layer, and thereby enables a higher current output.

Embodiments of the invention will now be described, by way of example, with reference to the accompanying drawings, in which:-

Figure 1 is a schematic representation of the high voltage thin film transistor described in the above-referenced European patent application,

Figure 2 is a tetrode structure configuration of this invention,

Figure 3 is another embodiment of the tetrode structure device, and

Figure 4 is a pentode structure configuration of this invention.

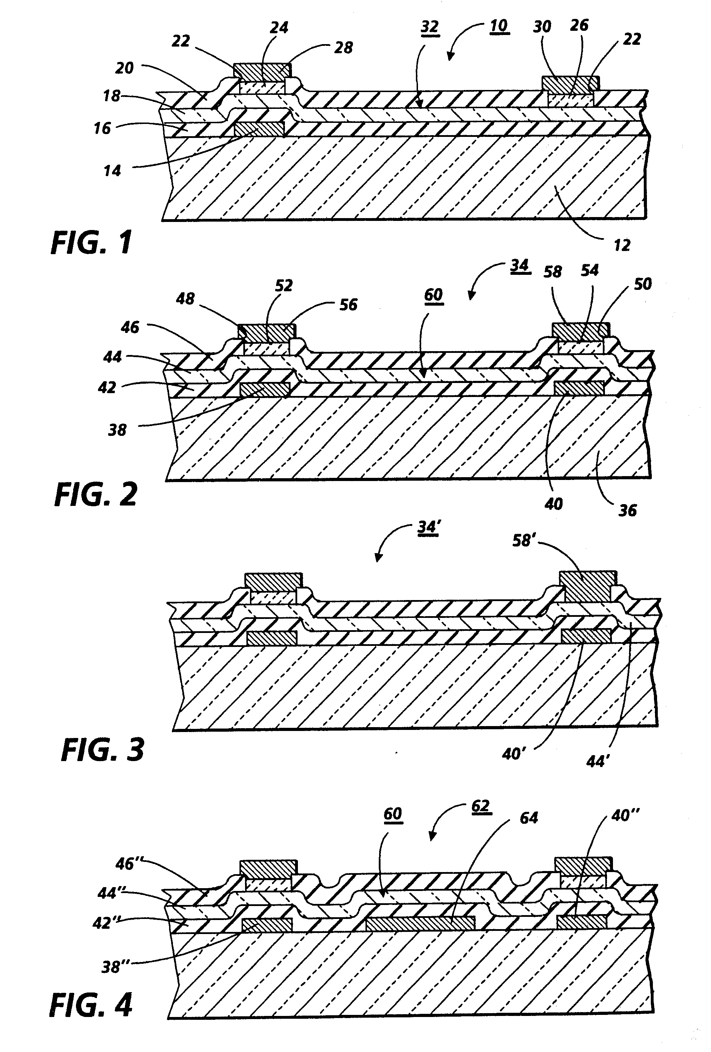

Turning now to Figure 1 of the drawings, there is illustrated the thin film transistor 10 of the aforementioned European patent application which has been enhanced and improved by the invention of this application. Transistor 10 includes a substrate 12, made of any suitable material, such as glass or ceramic, upon which is deposited a metal gate 14, which could be Cr, NiCr, or other material. A gate dielectric layer 16, usually silicon nitride or silicon dioxide overlies the substrate and the gate, and a charge carrier transport layer 18, comprising undoped or lightly doped amorphous semiconductor material, preferably amorphous silicon, overlies layer 16. A passivation dielectric layer 20, contiguous with the transport layer, is usually of the same material as the gate dielectric layer. Windows 22 etched in the passivation layer, provide openings in which injecting electrode 24 (source) and collecting electrode 26 (drain) are in physical and electrical contact with the transport layer 18. Source electrode 24 and drain electrode 26, preferably made of amorphous silicon are similarly, suitably doped so that the injecting electrode provide charge carriers of the desired type and the collecting electrode receives them, i. e. electrons (n+) or holes (p+). Source and drain contacts 28 and 30, made of a suitable conductive material, such as Al, overlie source and drain electrodes 24 and 26, respectively.

The spatial relationship of the source 24 and gate 14 is such that the relevant portion of each is the edge closest to the drain electrode 26, the edge remote from the drain electrode being of less concern to the operation of this device. Channel portion 32 of the transport layer 18 spans this lateral separation distance between the gate/source electrodes and the drain electrode. Because of the high resistivity of the transport layer (typically greater than $10_9$ ohm-cm), and the length of the channel (about 20 microns), the channel is able to sustain a high potential of several hundred volts, without electrical breakdown between the high potential drain and either the source or the gate. The small spacing between the source electrode and gate electrode (about 100 nm) relative to the great spacing between the source electrode and the drain electrode (about 20 microns), makes it possible for a very low switching potential (approximately 15 volts, or less) on the gate to suppress injection of charge carriers from the source into the transport layer, in its OFF state, and to cause injection of charge carriers from the source into the transport layer, in its ON state. Once charge carriers are injected into the transport layer, they come under the influence of the very high (several hundred volts) inter-electrode field and they will drift to the drain, causing current flow of about $10^{-7}$ amps.

One form of the present invention is illustrated in Figure 2. It should be understood that the materials comprising the various layers and elements will be the same as or equivalent to those used in the Figure 1 structure. Thin film tetrode device 34 is an improvement over the device 10 of Figure 1, and will have a substantially higher current output. It comprises a substrate 36 upon which are supported a first gate 38, a laterally spaced second gate 40, and a gate dielectric layer 42. A charge carrier transport layer 44 overlies the dielectric layer and itself supports a passivation layer 46 through which windows 48 and 50 have been formed for receiving an electron injecting electrode 52 and a hole injecting electrode 54. As in the Figure 1 device, the transport layer is undoped, or very lightly doped, however, the injecting electrodes are oppositely doped, n+ and p+, so as to inject electrons and holes, respectively. Metal contacts 56 and 58 overlie the electrodes 52 and 54.

The first gate electrode 38 and the second gate electrode 40 are located so as to be in face-to-face relationship with the electron injecting electrode 52 and the hole injecting electrode 54, whereby the laterally closest edges of each of the gate electrodes are slightly closer to one another than are the laterally closest edges of the electron injecting and hole injecting electrodes. The dimensions of this improved device are substantially the same as those of the high voltage thin film transistor of Figure 1. As in the Figure 1 device, the gate electrodes serve merely to control the rate of injection of charge carriers into the charge carrier transport layer 44 where they will drift to, and be collected by, the opposite injecting electrode. Multiple gates are employed in order to control the injection of charge carriers of opposite signs into the transport layer.

In Figure 3 there is shown an alternative configuration of the tetrode device 34, referenced as 34'. In it, the transport layer is intrinsic or lightly doped p and hole injection will also be possible if the doped amorphous silicon electrode (54) is omitted and instead metal contact 58' is contiguous with the transport layer 44'.

The devices of Figures 2 and 3 make it possible independently, to control the injection of electrons and holes into the transport layer 44/44' from the electron injecting electrode 52 and from the hole injecting electrode 54/58'. By selecting the appropriate potential on the control gates 38 and 40 it is possible to inject optimum numbers of charge carriers of each type so as to achieve higher device current output than had been possible by controlling the injection of but a single carrier type. Once having been injected into the transport layer, the charge carriers will drift to the opposite electrode.

In the Figure 1 device there is injection of but one carrier type. By being able, independently, with multiple gates, to control the injection of both carrier types into the transport layer, the total charge transport is increased. However, in spite of an expectation of higher current based upon this additive effect, such is not the case because holes have a lower carrier mobility than electrons and many will not flow entirely to the opposite electrode. Optimally, with equal numbers of injected electrons and holes, the best that could be expected would be a current increase of 10 to 30%. For amorphous silicon the mobility difference is much higher and the expectation for increased current is only about 1%. Advantageously, in this unique device, the increased current is not based merely upon the additive effect of the transport of charge carriers of both signs, but rather is space charge limited.

The space charge limited current through the transport layer of this thin film tetrode device is based on the net charge supportable by the applied voltage difference between the charge injecting electrodes. The plasma of electrons and holes in the semiconductor charge transport layer 44 represents a total amount of charge passing therethrough. It is this total amount of charge which carries the current. Where charge carriers of one type have been injected into the transport layer, as is the case when only charge carriers of one type are controlled (Figure 1), the total charge will be the same as the net charge. By independently controlling and introducing a large number of holes as well as electrons into the transport layer, these charge carriers neutralize one another vis-a-vis the external world and the total charge may be much greater than the net charge. Since the actual current is carried by the total charge and not by the net charge, it is possible to obtain substantial increase in current flow through this tetrode device.

As a hypothetical example, consider a device, of the Figure 1 type, in which the potential difference between source and drain electrodes will sustain a net charge of 10 electrons. The total charge transport will be 10 and will yield a certain current. Consider now a tetrode device as described herein. If one injects 1000 holes and 1010 electrons, the net charge will remain 10 electrons, but the total charge, and therefore the current, will have been increased 100-fold.

In Figure 4 there is illustrated a further enhancement of the Figure 2 device. It represents a thin film pentode device 62 having three control gate electrodes. In addition to gate electrodes 38" and 40" located opposite the injecting electrodes, a third gate electrode 64 has been added opposite the channel region 60". Electrode 64 affects the lateral transport of the injected charge carriers through the transport layer 44". By applying a voltage to the third gate electrode 64 a field is established, transversely, across the transport layer. The field serves to separate the holes and electrons by causing them to move in different zones of the channel region. The electrons will predominate in a lateral zone of channel region 60″ adjacent the gate dielectric layer 42″ and the holes will predominate in a lateral zone of the channel region adjacent the passivation dielectric layer 46″. By being separated, in this manner, the holes and electrons are prevented from recombining and eliminating each other, a mechanism which reduces the total charge in the transport layer. Thus, current flow is further increased.

It should be understood that the present disclosure has been made only by way of example, and that numerous changes in details of construction and the combination and arrangement of parts may be resorted to without departing from the scope of the invention as hereinafter claimed.

## Claims

1. A thin film transistor including
a charge transport layer,
an electron injecting electrode contiguous with said charge transport layer,
a hole injecting electrode contiguous with said charge transport layer,
said electron injecting and hole injecting electrodes having their facing edges laterally spaced relative to one another by a first distance which defines the channel region of said charge transport layer,
a dielectric layer having one side contiguous with the opposite side of said charge transport layer and sustantially coextensive with the entire lateral dimension of said charge transport layer, and
first and second control electrodes each being located in facing relationship with one of said injecting electrodes so that the facing edges of said control electrodes are laterally spaced from one another by substantially said first distance, said control electrodes being spaced from said charge transport layer by the dielectric layer, the facing surfaces of said control electrodes and said injecting electrodes being separated by a second distance which is substantially smaller than said first distance, whereby electrons and holes may be selectively injected into said charge transport layer and each will travel in a direction opposite to the other across said channel region.

2. The thin film transistor as recited in claim 1 characterized in that said injecting electrodes are oppositely doped in order for each to inject either electrons or holes in accordance with its doping.

3. The thin film transistor as recited in claim 1 characterized in that said charge transport layer is doped, one of said injecting electrodes is oppositely doped and said other injecting electrode comprises an electrically conductive contact contiguous with said charge transport layer.

4. The thin film transistor as recited in claim 3 characterized in that said charge transport layer is doped p+, one of said injecting electrodes is doped n+ and said other injecting electrode comprises a metal contact.

5. The thin film transistor as recited in any preceding claim characterized in that said first distance is about a hundred times greater than said second distance.

6. The thin film transistor as recited in any preceding claim characterized by further including a third control electrode facing said channel region and spaced from said charge transport layer by the dielectric layer, said third control electrode affecting the lateral transport of the injected electrons and holes by causing them to move in separated lateral paths of said channel region.

7. The thin film transistor as recited in any preceding claim characterized in that said charge carrier transport means comprises an amorphous silicon layer.

0279638

FIG. 1

FIG. 2

FIG. 3

FIG. 4